# EUROPEAN PATENT APPLICATION

(11) **EP 4 358 403 A1**
(43) Date of publication of application: **24.04.2024**
(21) Application number: 22871042.2
(22) Date of filing: 09.10.2022
(51) Int. Cl.: H03H 9/02, H03H 9/56, H03H 9/58, H03H 3/02

(54) **RESONATOR, FILTER, ELECTRONIC DEVICE, AND PREPARATION METHOD FOR RESONATOR**

(30) Priority: 25.08.2022 CN 202211024843
(71) Applicant: JWL (Zhejiang) Semiconductor Co., Ltd., Huzhou, Zhejiang 313000 (CN)
(72) Inventor: LI, Linping, Zhejiang 313000 (CN)
(74) Representative: Kolster Oy Ab
(86) International application number: PCT/CN2022/124066
(87) International publication number: WO 2024/040696

(57) **Abstract**

A resonator is provided. The resonator includes a substrate, a bottom electrode, a piezoelectric layer and a top electrode. The bottom electrode is arranged between the substrate and the piezoelectric layer, the piezoelectric layer is arranged between the bottom electrode and the top electrode, and a multilayer cavity is arranged between the bottom electrode and the substrate. The multilayer cavity has a width gradually decreased in a direction away from the substrate, so that the change in shapes of the bottom electrode and the piezoelectric layer subsequently arranged on the multilayer cavity at a boundary of each layer of the multilayer cavity is reduced, thus reducing the change in stress due to a large change in shape. Further, with the slow change in shape, the growth qualities of the bottom electrode and the piezoelectric layer are improved, reducing the growth defects and improving the Q value of the device. In addition, the height of the release channel, that is a height of a cavity closest to the substrate, is reduced, so that the change in the shape of the piezoelectric layer covering the cavity closest to the substrate is reduced, thereby reducing the change in stress of the piezoelectric layer. A filter, an electronic device and a method for manufacturing a resonator are further provided.

## Description

### FIELD

This application claims the priority to Chinese Patent Application No. 202211024843.6, titled "RESONATOR, FILTER, ELECTRONIC DEVICE, AND METHOD FOR MANUFACTURING RESONATOR", filed on August 25, 2022 with the China National Intellectual Property Administration, which is incorporated herein by reference in its entirety.

### BACKGROUND

With the increasingly crowded of electromagnetic spectrums, the increasing frequency bands and functions of wireless communication devices, and the rapid growth of electromagnetic spectrums of wireless communication from 500 MHz to more than 5 GHz, radio frequency front-end modules with high performance, low cost, low power consumption and small size are increasingly required. As a radio frequency front-end module, the filter plays an important role in improving the transmission and reception of signals.

The filter including multiple resonators connected to each other in a topological network structure has the features of small size, high integration, high quality factor at a high frequency and strong power tolerance, meeting the high requirements for the radio frequency front-end module. Therefore, the manufacture of high-performance resonators becomes a hot research topic.

The resonator has a basic structure including a top electrode, a bottom electrode and a piezoelectric layer arranged between the top electrode and the bottom electrode. An upper surface of the top electrode is in contact with the air, so that a sound wave is completely reflected at the junction of the top electrode and the air, thus suppressing energy leakage. An acoustic reflection structure is arranged below the bottom electrode to prevent the energy from leaking to the substrate, so that the energy is stored in the resonator. An overlapping region of the top electrode, the piezoelectric layer, the bottom electrode and the acoustic reflection structure forms an active region of the resonator.

The resonator includes a film bulk acoustic resonator (FBAR) and a solidly mounted resonator (SMR) according to the acoustic reflection structure. The FBAR has an acoustic reflection structure of a cavity, and the SMR has an acoustic reflection structure of a Bragg reflector. According to the position of the cavity, the cavity of the film bulk acoustic resonator may be an underground cavity embedded in the substrate or an aboveground cavity arranged on a surface of the substrate.

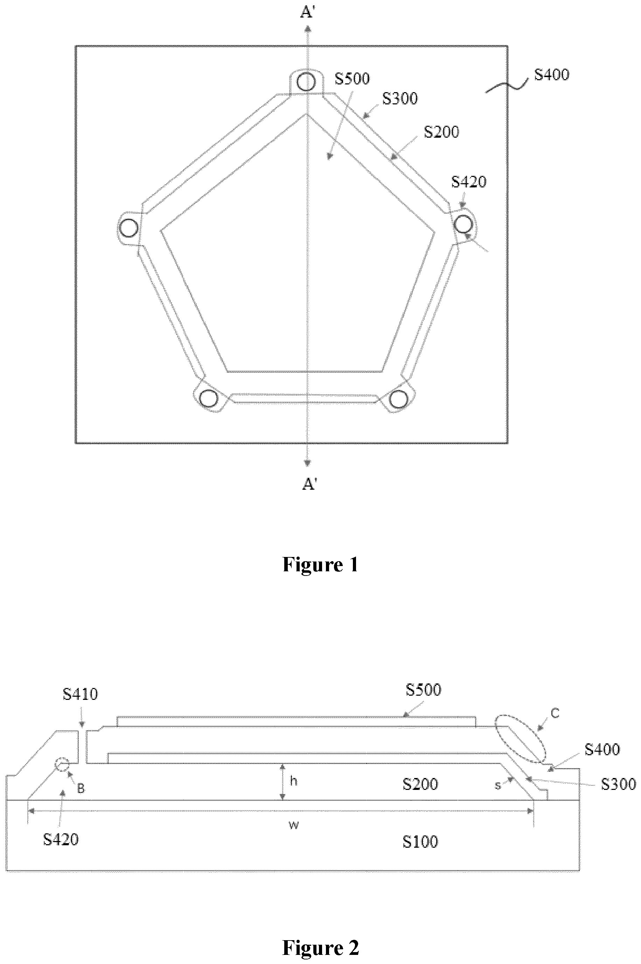

As shown in Figure 1 and Figure 2, a side of the aboveground cavity is inclined. To ensure the height of the cavity, the side of the aboveground cavity has a large inclination angle due to the limitation of the etching process. Thus, a bottom electrode and a piezoelectric layer arranged on the inclined side have large morphological changes, resulting in a large sudden change in stress, and easily producing large cracks and defects.

In addition, in generating a cavity, a sacrificial layer is first formed, then a release hole is formed above the sacrificial layer by performing the etching process to penetrate at least the piezoelectric layer. The corrosive solution flows through the release hole to contact with the sacrificial layer to remove the sacrificial layer, thus forming the cavity. If the release hole is defined inside the resonator, the area of the active region is reduced. Therefore, the release hole is defined on the periphery of the resonator to ensure the area of the active region. However, in order to form the release hole, a part of the cavity is required to protrude outward. The piezoelectric layer covering on the protruded part (such as a part at a position of a release channel in Figure 1 and a part at a B position in Figure 2) of the cavity may cause a sudden change in stress, affecting the piezoelectric performance and the reliability of the cavity structure near the active region, and resulting in a mechanical breakage of the cavity at the position where the sudden change in stress occurs.

Therefore, how to reduce the change of stress in the piezoelectric layer of a resonator having an aboveground cavity is a problem to be urgently solved by those skilled in the art.

### SUMMARY

An electronic device, a filter, a resonator and a method for manufacturing a resonator are provided according to the present disclosure to effectively reduce the change of stress in the piezoelectric layer.

In order to solve the above technical problem, a resonator is provided according to the present disclosure. The resonator includes a substrate, a bottom electrode, a piezoelectric layer and a top electrode. The bottom electrode is arranged between the substrate and the piezoelectric layer, and the piezoelectric layer is arranged between the bottom electrode and the top electrode. A multilayer cavity is arranged between the bottom electrode and the substrate, and the multilayer cavity has a width gradually decreased in a direction away from the substrate.

In an embodiment, in the resonator, the multilayer cavity includes a first cavity close to the substrate and a second cavity close to the bottom electrode, and the first cavity surrounds the second cavity.

In an embodiment, in the resonator, the first cavity is different from the second cavity in shape.

In an embodiment, in the resonator, a part of the first cavity protrudes outward in a direction parallel to the substrate to form a release channel.

In an embodiment, in the resonator, the first cavity has multiple corners, and at least one of the corners protrudes outward in the direction parallel to the substrate to form the release channel.

In an embodiment, in the resonator, the piezoelectric layer above the release channel is arranged with a release hole for connecting the release channel with an outside to release a sacrificial layer in the multilayer cavity.

In an embodiment, in the resonator, the corners are arranged to be arc-shaped or angle-shaped.

In an embodiment, in the resonator, sides of the multilayer cavity are arranged to be inclined-shaped, arc-shaped or step-shaped.

In an embodiment, in the resonator, the sides of the multilayer cavity are arranged to be inclined-shaped at a same inclination angle.

In an embodiment, in the resonator, an edge of a cavity in the multilayer cavity close to the bottom electrode is retracted inward by 1µm to 10µm relative to an edge of a cavity in the multilayer cavity close to the substrate.

In an embodiment, in the resonator, a height of a cavity in the multilayer cavity close to the substrate is greater than a height of a cavity in the multilayer cavity close to the bottom electrode.

A filter is further provided according to the present disclosure. The filter includes the resonator described above.

An electronic device is further provided according to the present disclosure. The electronic device includes the resonator described above.

A method for manufacturing a resonator is further provided according to the present disclosure. The method for manufacturing a resonator includes: obtaining a substrate; arranging a bottom electrode on the substrate; arranging a piezoelectric layer on the bottom electrode; and arranging a top electrode on the piezoelectric layer. A multilayer cavity is arranging between the substrate and the bottom electrode, and the multilayer cavity has a width gradually decreased in a direction away from the substrate.

In an embodiment, in the method for manufacturing a resonator, the multilayer cavity is arranged by: arranging multiple sacrificial layers between the substrate and the bottom electrode; and removing the multiple sacrificial layers after the top electrode is arranged.

In an embodiment, in the method for manufacturing a resonator, a material of a sacrificial layer closest to the substrate is the same or different from a material of other sacrificial layers.

In an embodiment, in the method for manufacturing a resonator, materials of the sacrificial layers contain phosphorus.

In an embodiment, in the method for manufacturing a resonator, the material of the sacrificial layer closest to the substrate contains more phosphorus than the material of the other sacrificial layers, and a release speed of the sacrificial layer closest to the substrate is greater than a release speed of the other sacrificial layers.

The resonator according to the present disclosure has the following beneficial effects.
1. The width of the multilayer cavity gradually decreases in a direction from the substrate to the top electrode, and the piezoelectric layer is covered on the multilayer cavity, so that the shape of the piezoelectric layer at the edge of the active region slowly changes, reducing the shape change of the piezoelectric layer and reducing the stress change of the piezoelectric layer, thereby improving the piezoelectric performance of the piezoelectric layer.
2. Due to the reduction of the height of the release channel, the shape change of the piezoelectric layer covering the release channel at the edge of the release channel is reduced, reducing the stress change, thereby improving the mechanical stability of the device structure.

A filter and an electronic device applying the resonator and a method for manufacturing the resonator are further provided according to the present disclosure. Therefore, the filter, the electronic device and the method for manufacturing the resonator have the above beneficial effects, which are not repeated herein.

### BRIEF DESCRIPTION OF THE DRAWINGS

In order to more clearly illustrate technical solutions in embodiments of the present disclosure or in the conventional technology, the drawings to be used in the description of the embodiments or the conventional technology are briefly described below. Apparently, the drawings in the following description show only some embodiments of the present disclosure, and other drawings may be obtained by those skilled in the art from the drawings without any creative work.
Figure 1 is a top view of a film bulk acoustic resonator according to an embodiment in the background technology;
Figure 2 is a sectional view of the film bulk acoustic resonator shown in Figure 1 along an A'-A' direction;
Figure 3 is a top view of a resonator according to an embodiment of the present disclosure;
Figure 4 is a sectional view of the resonator shown in Figure 3 along an A-A direction; and
Figures 5 to 9 are schematic structural diagrams of a method for manufacturing a resonator according to an embodiment of the present disclosure.

Reference numerals in Figure 1 and Figure 2 are listed as follows:
- S100: substrate
- S200: cavity
- S300: bottom electrode
- S400: piezoelectric layer
- S410: release hole
- S420: release channel
- S500: top electrode

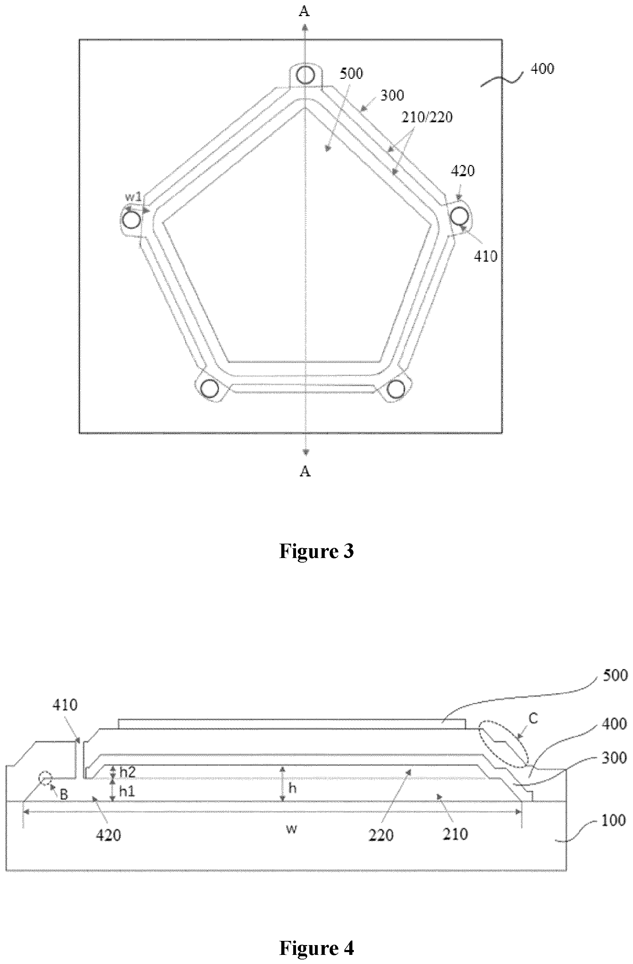

Reference numerals in Figure 3 to Figure 9 are listed as follows:
- 100: substrate
- 210: first cavity
- 220: second cavity
- 300: bottom electrode
- 400: piezoelectric layer
- 410: release hole
- 420: release channel
- 500: top electrode
- 600: sacrificial layer
- B: shape of piezoelectric layer
- C: edge of active region of piezoelectric layer.

### DETAILED DESCRIPTION

The embodiments of the present disclosure are described in detail hereinafter, and examples of the embodiments are shows in drawings, in which the same or similar reference numerals represent the same or similar components or components having the same or similar functions throughout the description. The embodiments described below with reference to the drawings are only exemplary embodiments which are used to explain the present disclosure, and should not be understood as a limitation of the present disclosure.

In the description of the present disclosure, it should be understood that in the description of an orientation, an orientation or a position relation indicated by a term such as "upper", "lower", "front", "back", "left", "right" or the like is described based on an orientation or a position relation shown in the drawings, and is only used for describing the present disclosure and simplifying the description, rather than instructing or implying that a device or element related to the terms has a specific orientation or is constructed and operated in a specific orientation. Therefore, the terms should not be understood as a limitation of the present disclosure.

In the description of the present disclosure, the term "multiple" indicates two or more. The terms of "first" and "second" in the description are only used for distinguishing technical features, and cannot be understood as indicating or implying relative importance or implicitly indicating the number of indicated technical features or implicitly indicating a sequence of the indicated technical features.

In the description of the present disclosure, terms, such as "set", "install", and "connect", should be understood broadly unless otherwise specifically defined. Those skilled in the art may reasonably determine the specific meaning of the above terms in the present disclosure in conjunction with the content of the technical solution.

An electronic device, a filter, a resonator, and a method for manufacturing a resonator are provided according to the present disclosure to effectively reduce the stress change in a piezoelectric layer.

In order to enable those skilled in the art to well understand the technical solutions of the present disclosure, the present disclosure is further described in detail below with reference to the drawings and embodiments.

Referring to the conventional resonator shown in Figure 1 and Figure 2 in the background technology, in a case that a height h of the cavity is constant, an inclination s of a side of the cavity is negatively correlated with a width w of the cavity. That is, a smaller inclination indicates a smaller change in the shape of the piezoelectric layer and a smaller stress change of the piezoelectric layer. However, a wider cavity indicates a resonator having a larger size, which is not conducive to the miniaturization of the resonator. In a case that the width w is constant, the inclination s is positively correlated with the height h. That is, a smaller inclination indicates a smaller change in the shape of the piezoelectric layer and a smaller stress change of the piezoelectric layer. However, a smaller height of the cavity indicates a risk of adhesion between a resonant film and the substrate when the resonator resonates.

In a case that the shape of the piezoelectric layer greatly changes, the sudden change in the stress of the piezoelectric layer is large, resulting in uneven film stress distribution, and further resulting in energy loss, film bulge or other problems, greatly reducing performance of a device and even damaging the device. In particular, for a high-frequency device above 2.5GHz, the performance, yield, and reliability of the resonator may be reduced due to the uneven film stress distribution.

Therefore, in order to reduce the sudden change of the stress of the piezoelectric layer at the edge of the active region, the inclination s of the cavity may be reduced while keeping the height h and the width w of the cavity unchanged.

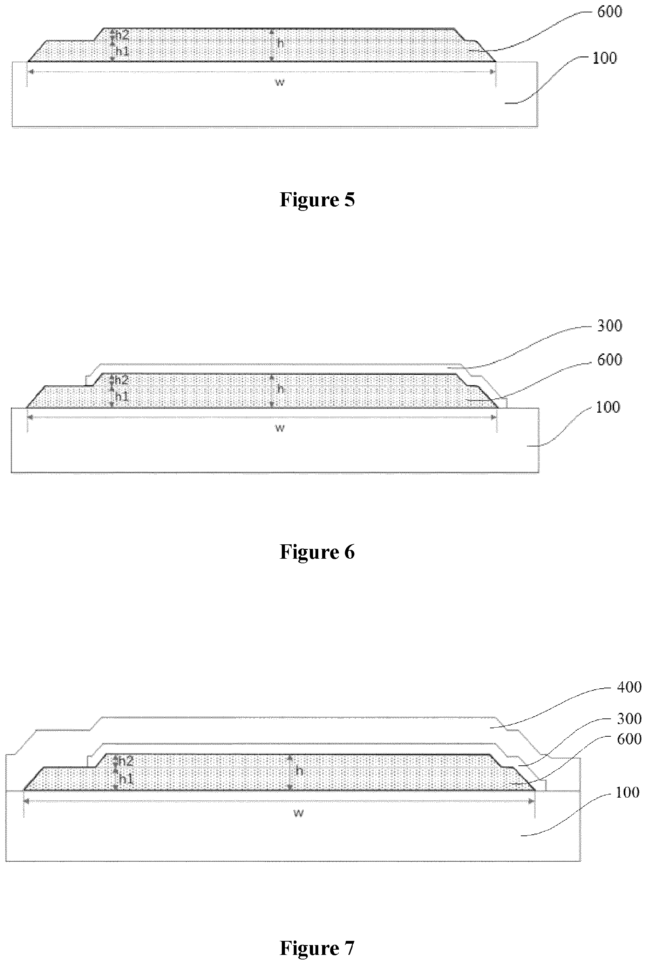

Based on the above analysis, as shown in Figure 3 to Figure 9, Figure 3 is a top view of a resonator according to an embodiment of the present disclosure, Figure 4 is a sectional view of the resonator shown Figure 3 along an A-A direction, and Figures 5 to 9 are schematic structural diagrams of a method for manufacturing a resonator according to an embodiment of the present disclosure.

A resonator is provided according to an embodiment of the present disclosure. The resonator includes a substrate 100, a bottom electrode 300, a piezoelectric layer 400 and a top electrode 500. The bottom electrode 300 is arranged between the substrate 100 and the piezoelectric layer 400, and the piezoelectric layer 400 is arranged between the bottom electrode 300 and the top electrode 500.

A multilayer cavity is arranged between the bottom electrode 300 and the substrate 100, and the multilayer cavity has a width gradually decreased in a direction away from the substrate 100. The bottom electrode 300 covers an upper surface of the multilayer cavity, and extends to the substrate 100 to form a cavity above the substrate 100. A side of the bottom electrode 300 is a part of the cavity. The piezoelectric layer 400 covers the multilayer cavity and the bottom electrode 300, and two ends of the piezoelectric layer 400 extend to the substrate 100. The piezoelectric layer 400 has an unchanged thickness in a direction parallel to the substrate 100. The top electrode 500 is arranged on the piezoelectric layer 400, and at least one end of the top electrode 500 is arranged inside an edge of the cavity. For example, a non-connecting end of the top electrode 500 that is not connected to the outside is arranged inside the edge of the cavity. Thus, additional parasitic oscillation caused by overlapping of the top electrode 500, the piezoelectric layer 400 and the bottom electrode 300 is avoided.

In the present disclosure, the aboveground cavity is configured as a multilayer cavity, and the width of the multilayer cavity is gradually reduced in the direction away from the substrate 100, so that the change in shapes of the bottom electrode 300 and the piezoelectric layer 400 subsequently arranged on the multilayer cavity at a boundary of each layer of the multilayer cavity is reduced. For example, at an edge of an active region, that is, at the position C, one great change in the shape of the piezoelectric layer 400 is converted to multiple small changes in the shape of the piezoelectric layer 400, thus the shape of the bottom electrode 300 and the shape of the piezoelectric layer 400 change slowly at the edge of the multilayer cavity, thereby reducing the change in stress due to a large change in shape. In addition, with the slow change in shape, the growth qualities of the bottom electrode 300 and the piezoelectric layer 400 are improved, reducing growth defects and improving the Q value of the device.

In addition, a part of a cavity close to the substrate 100 protrudes outward to form a release channel 420, and a release hole 410 is arranged on the piezoelectric layer 400 above the release channel 420. Release solution enters into the cavity through the release hole and the release channel to contact with and react with the sacrificial layer 600 in the cavity to release the sacrificial layer 600 to form a new cavity. A height of the release channel 420 is equal to a height of the layer of the cavity closest to the substrate 100. Compared with the height of the multilayer cavity, the height of the release channel 420 is reduced, so that the change in the shape of the piezoelectric layer 400 covering the layer of the cavity closest to the substrate 100 is reduced, thereby reducing the change in the stress of the piezoelectric layer 400. Moreover, the effective area of the resonator is maximized and the layout flexibility of the release channel 420 is improved, thereby facilitating the connection layout of the resonator.

In an embodiment, as shown in Figures 3 and 4, the multilayer cavity includes at least a first cavity 210 close to the substrate 100 and a second cavity 220 close to the bottom electrode 300. The first cavity 210 surrounds the second cavity 220. The first cavity 210 protrudes outward in the direction parallel to the substrate 100 to form more than one release channel 420, so that the shape of the first cavity 210 is different from the shapes of other cavities due to a protruded part.

It should be understood that a shape of at least one layer of cavity (that is, the cavity closest to the substrate 100) is different from shapes of other layers of cavities, and the shapes of the other layers of cavities may be set to be the same or different.

The multilayer cavity may be in a regular polygon shape or in an irregular polygon shape, which is not limited in the embodiment. In an embodiment, the first cavity 210 has multiple corners, and at least one of the corners protrudes outward in the direction parallel to the substrate 100 to form the release channel 420. In addition to the first cavity 210, each of other cavities may have multiple corners. In order to reduce the change in stress, the corners may be designed to be arc-shaped or angle-shaped, such as right-angle shaped.

It should be noted that the release channel 420 may be arranged at a corner of the second cavity 220 or another position of the second cavity 220, which is not limited in the embodiment. At least one release channel 420 is arranged. In order to accelerate the release of the sacrificial layer 600, multiple release channels 420 may be arranged.

Sides of the multilayer cavity are inclined-shaped, arc-shaped or step-shaped. Inclination angles of the multilayer cavity may be the same or different, and may be determined according to actual stress. The heights of the multilayer cavity may be set in any scale. In an embodiment, in order to reduce change in stress, an edge of a cavity close to the bottom electrode 300 is retracted inward by 1µm to 10µm with respect to an edge of a cavity close to the substrate 100, and a height of the cavity close to the substrate 100 is greater than a height of the cavity close to the bottom electrode 300, to facilitate the release of the sacrificial layer 600.

According to the conventional technology, the release hole 410 is usually defined on a periphery of a cavity, for example, on a sloping side of the sacrificial layer 600. In a case that the release hole 410 is arranged close to an active region, the stress distribution in the active region may be destroyed, resulting in a larger piezoelectric change in the active region, affecting the yield of the resonator. In addition, the process requirement for defining a release hole 410 on the sloping side is high, resulting in an increase of the process cost. According to the present disclosure, the release hole 410 is defined on a platform between the first cavity 210 and the second cavity 220, rather than on a sloping side, facilitating processing and reducing process requirements.

A two-layer cavity is described below as an example. The second cavity 220 is approximately pentagonal. The first cavity 210 is defined on the periphery of the second cavity 220, and protrudes outward at positions corresponding to the five corners of the second cavity 220 to form five release channels 420. The release holes 410 are defined on the release channels 420.

A width of the first cavity 210 is about 1µm to 10µm greater than a width of the second cavity 220. In a preferred embodiment, the width of the first cavity 210 is 3µm greater than the width of the second cavity 220. A height h1 of the first cavity 210 is greater than a height h2 of the second cavity 220 to reduce the change in the stress of the piezoelectric layer 400 at the edge of the active region. In other embodiments, h1 may be equal to or less than h2, which is not further limited in the embodiment.

A width w1 (as shown in Figure 3) of the release channel 420 is greater than 15µm, and a diameter of the release hole 410 is less than 20µm. In a preferred embodiment, the diameter of the release hole 410 is 10µm.

Inclination angles of sides of the two cavities may be the same, such as 30° or 45°. Alternatively, the inclination angles of the sides of the two cavities may be different, for example, the inclination angle of the upper cavity is 15°, and the inclination angle of the lower cavity is 30°. The inclination angles may further set according to the actual application.

In addition, a filter is further provided according to the present disclosure, and the filter includes the resonator described above. An electronic device is further provided according to the present disclosure, and the electronic device includes the resonator described above.

It should be understood that the core of the present disclosure is the resonator described above. For other structures in the filter and the electronic device according to the embodiment, one may refer to the relevant conventional technology, which is not described in detail herein.

Referring to Figures 5 to 9, a method for manufacturing a resonator is further provided according to an embodiment of the present disclosure. The method is applied to the resonator described above. The method for manufacturing a resonator includes the following steps 1 to 5.

In step 1, as shown in Figure 5, a substrate 100 is provided. An upper surface of the substrate 100 is covered with a sacrificial layer 600. The sacrificial layer 600 is patterned by etching. The sacrificial layer 600 has at least two layers. A part of the sacrificial layer 600 close to the substrate 100 protrudes outward.

In step 2, as shown in Figure 6, a bottom electrode 300 is formed on a surface of the patterned sacrificial layer 600 and a surface of the substrate 100. A part of the bottom electrode 300 is arranged on a protruded part of the sacrificial layer 600. The bottom electrode 300 covers a surface of a non-protruding part of the sacrificial layer 600 and extends to the substrate 100.

In step 3, as shown in Figure 7, a piezoelectric layer 400 is formed on a surface of the bottom electrode 300. The piezoelectric layer 400 covers the sacrificial layer 600 and the bottom electrode 300, and extends to the substrate 100.

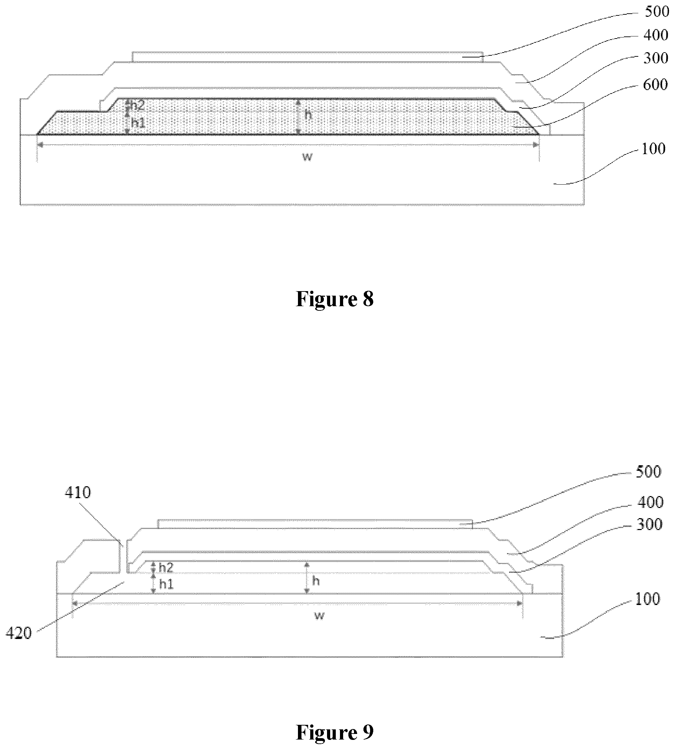

In step 4, as shown in Figure 8, a top electrode 500 is arranged on a surface of the piezoelectric layer 400. The top electrode 500 is etched, so that a non-connecting end of the top electrode 500 is arranged inside an edge of the sacrificial layer 600 based on which a cavity is to be formed.

In step 5, as shown in Figure 9, the piezoelectric layer 400 above the protruded part of the sacrificial layer 600 is etched to the sacrificial layer 600 to form a release hole 410, thus the sacrificial layer 600 is released. The protruded part forms a release channel 420, and a multilayer cavity is formed between the bottom electrode 300 and the substrate 100. The width of the multilayer cavity gradually decreases in a direction away from the substrate 100.

Based on the above method for manufacturing a resonator, a material of a sacrificial layer 600 closest to the substrate 100 is the same or different from a material of other the sacrificial layers 600. Materials of the sacrificial layer 600 contain at least phosphorus. The materials of the sacrificial layers 600 may contain metals such as Ge, Sb, Ti, Al and Cu, phosphate silicate glass (PSG), or polymers. In a preferred embodiment, the materials of the sacrificial layers 600 contain phosphorus-doped SiO₂ (PSG). Alternatively, the materials of the sacrificial layers 600 may contain Si, Poly (polycrystalline silicon) or other dielectric materials, or a combination of metal materials and dielectric materials. The dielectric or the metal may be obtained by performing CVD process, PVD process, evaporation plating process or other processes.

Further, a release speed of the sacrificial layer 600 closest to the substrate 100 is greater than a release speed of the sacrificial layer 600 close to the bottom electrode 300. For example, the metals such as Ti and Al may be contained in the sacrificial layer 600 close to the substrate, and then are rapidly dissolved in hydrofluoric acid to achieve the release effect. Alternatively, the sacrificial layer 600 closest to the substrate 100 contains more phosphorus than the other sacrificial layers 600, so that the release speed of the sacrificial layer 600 closest to the substrate 100 is greater than the release speed of the other sacrificial layers 600. Thus, the sacrificial layer 600 close to the bottom electrode 300 releases slowly, thereby reducing the stress.

In an embodiment, the material of the substrate 100 may include silicon (Si), sapphire, polycrystalline silicon (poly), silicon dioxide (SiO₂), gallium arsenide (GaAs), spinel, glass or ceramic material. The material of the substrate 100 is preferably silicon (Si). The material of the bottom electrode 300 may include gold (Au), molybdenum (Mo), ruthenium (Ru), aluminum (Al), platinum (Pt), titanium (Ti), tungsten (W), palladium (Pd), chromium (Cr), nickel (Ni), or the like. The material of the bottom electrode 300 is preferably molybdenum (Mo). The material of the piezoelectric layer 400 may include zinc oxide (ZnO), zinc sulfide (ZnS), aluminum nitride (AlN), cadmium sulfide (CdS), lead titanate [PT](PbTiO₃), lead zirconate titanate [PZT](Pb(Zr,Ti)O₃), lithium tantalate (LiTaO₃), lithium niobate (LiNbO₃), or other materals in lead zirconate lanthanum series. The material of the piezoelectric layer 400 is preferably aluminum nitride (AlN). The materials of the top electrode 500 and the bottom electrode 300 may be the same or different, and may include gold (Au), molybdenum (Mo), ruthenium (Ru), aluminum (Al), platinum (Pt), titanium (Ti), tungsten (W), palladium (Pd), chromium (Cr), nickel (Ni), or the like. In a preferred embodiment, the materials of the top electrode 500 and the bottom electrode 300 are the same, and are molybdenum (Mo).

The embodiments in this specification are described in a progressive manner. Each embodiment focuses on differences from other embodiments. The same and similar parts between embodiments are referred to each other.

Specific examples are used in this specification to illustrate the principle and implementation of the present disclosure. The description of the above embodiments is only used to facilitate understanding of the method and core concept of the present disclosure. It should be noted that, for those skilled in the art, many improvements and modifications may be further made to the present disclosure without departing from the principle of the present disclosure, and these improvements and modifications also fall within the protection scope of claims of the present disclosure.

## Claims

1. A resonator, comprising: a substrate, a bottom electrode, a piezoelectric layer and a top electrode, wherein the bottom electrode is arranged between the substrate and the piezoelectric layer, and the piezoelectric layer is arranged between the bottom electrode and the top electrode, wherein
a multilayer cavity is arranged between the bottom electrode and the substrate, and the multilayer cavity has a width gradually decreased in a direction away from the substrate.

2. The resonator according to claim 1, wherein the multilayer cavity comprises a first cavity close to the substrate and a second cavity close to the bottom electrode, and the first cavity surrounds the second cavity.

3. The resonator according to claim 2, wherein the first cavity is different from the second cavity in shape.

4. The resonator according to claim 3, wherein a part of the first cavity protrudes outward in a direction parallel to the substrate to form a release channel.

5. The resonator according to claim 4, wherein the first cavity has a plurality of corners, and at least one of the corners protrudes outward in the direction parallel to the substrate to form the release channel.

6. The resonator according to claim 4, wherein the piezoelectric layer above the release channel is arranged with a release hole for connecting the release channel with an outside to release a sacrificial layer in the multilayer cavity.

7. The resonator according to claim 5, wherein the corners are arranged to be arc-shaped or angle-shaped.

8. The resonator according to claim 1, wherein sides of the multilayer cavity are arranged to be inclined-shaped, arc-shaped or step-shaped.

9. The resonator according to claim 8, wherein the sides of the multilayer cavity are arranged to be inclined-shaped at a same inclination angle.

10. The resonator according to claim 1, wherein an edge of a cavity in the multilayer cavity close to the bottom electrode is retracted inward by 1µm to 10µm relative to an edge of a cavity in the multilayer cavity close to the substrate.

11. The resonator according to claim 1, wherein a height of a cavity in the multilayer cavity close to the substrate is greater than a height of a cavity in the multilayer cavity close to the bottom electrode.

12. A filter, comprising the resonator according to any one of claims 1 to 11.

13. An electronic device, comprising the resonator according to any one of claims 1 to 11.

14. A method for manufacturing a resonator, comprising:
obtaining a substrate;
arranging a bottom electrode on the substrate;
arranging a piezoelectric layer on the bottom electrode; and
arranging a top electrode on the piezoelectric layer; wherein
a multilayer cavity is arranged between the substrate and the bottom electrode, and the multilayer cavity has a width gradually decreased in a direction away from the substrate.

15. The method for manufacturing a resonator according to claim 14, wherein the multilayer cavity is arranged by:
arranging a plurality of sacrificial layers between the substrate and the bottom electrode, and removing the plurality of sacrificial layers after the top electrode is arranged.

16. The method for manufacturing a resonator according to claim 15, wherein
a material of a sacrificial layer closest to the substrate is the same or different from a material of other sacrificial layers.

17. The method for manufacturing a resonator according to claim 16, wherein materials of the sacrificial layers contain phosphorus.

18. The method for manufacturing a resonator according to claim 17, wherein the material of the sacrificial layer closest to the substrate contains more phosphorus than the material of the other sacrificial layers, and a release speed of the sacrificial layer closest to the substrate is greater than a release speed of the other sacrificial layers.
